# EUROPÄISCHE PATENTSCHRIFT

(11) **EP 1 379 884 B1**
(45) Veröffentlichungstag und Bekanntmachung des Hinweises auf die Patenterteilung: **10.10.2007**
(21) Anmeldenummer: 02714049.0
(22) Anmeldetag: 20.02.2002
(51) Int. Cl.: G01P 15/125, G01P 15/08, B81B 7/00

(54) **SENSOR**
SENSOR
DETECTEUR

(30) Priorität: 05.04.2001 DE 10116931
(43) Veröffentlichungstag der Anmeldung: 14.01.2004
(73) Patentinhaber: ROBERT BOSCH GMBH, 70442 Stuttgart (DE)
(72) Erfinder: FRANZ, Jochen, 72762 Reutlingen (DE); KOHN, Oliver, 72768 Reutlingen (DE); HENNING, Frank, 72770 Reutlingen (DE); MAUTE, Matthias, 72072 Tuebingen (DE)
(86) Internationale Anmeldenummer: PCT/DE2002/000621
(87) Internationale Veröffentlichungsnummer: WO 2002/082096

(56) Entgegenhaltungen:
- WO-A-01/98786
- DE-A- 19 817 357
- DE-A- 19 825 298
- DE-A- 19 930 779
- JP-A- 9 127 151
- US-A- 6 005 275
- PATENT ABSTRACTS OF JAPAN vol. 2000, no. 15, 6. April 2001 (2001-04-06) -& JP 2000 338126 A (MATSUSHITA ELECTRIC WORKS LTD), 8. Dezember 2000 (2000-12-08)

## Beschreibung

### Stand der Technik

Die Erfindung betrifft einen Sensor, dessen Sensorstruktur in einem mikromechanischen Bauelement realisiert ist und gegenüber dem feststehenden Substrat des Bauelements bewegliche Teile aufweist. Die Sensorstruktur umfasst mindestens eine freitragende seismische Masse und eine Federanordnung mit mindestens einer Feder, wobei die seismische Masse über die Federanordnung mit dem Substrat verbunden ist. Die Sensorstruktur umfasst ferner einen Überlastschutz zum Begrenzen der Auslenkung der Federanordnung bzw. der seismischen Masse in mindestens einer Richtung. Der Sensor ist außerdem mit Mitteln zum Erfassen der Auslenkungen der Federanordnung bzw. der seismischen Masse ausgestattet.

Aus der Praxis ist ein derartiger Sensor bekannt, der als Beschleunigungssensor konzipiert ist. Die freitragende seismische Masse ist dazu in Form einer Wippe ausgebildet, die über zwei Torsionsfedern mit dem feststehenden Substrat des Bauelements zum einen mechanisch verbunden ist und zum anderen auch elektrisch kontaktiert ist. Während die Massenverteilung der Wippe unsymmetrisch bezüglich der Anordnung der Torsionsfedern ist, weist die Wippe zwei symmetrisch zu dieser Federanordnung angeordnete und ausgebildete Kapazitätsflächen auf, die zusammen mit dem Substrat jeweils eine Kapazität bilden. Eine auf die Sensorstruktur einwirkende Beschleunigung verursacht eine Verdrehung und/oder Verkippung der Wippe um die Federanordnung und damit eine Änderung der Kapazitätsdifferenz zwischen diesen beiden Kapazitäten. Durch Auswertung der Kapazitätsdifferenz bzw. deren Änderung kann die auf die Sensorstruktur einwirkende Beschleunigung bestimmt werden. Der bekannte Beschleunigungssensor weist eine vertikale Empfindlichkeit auf, so dass sich mit dem bekannten Sensor Beschleunigungen senkrecht zur Chipebene erfassen lassen.

Die beweglichen Teile der Sensorstruktur des bekannten Sensors lassen sich nur innerhalb gewisser Grenzen auslenken, ohne dass mechanische Schäden, wie z.B. ein Federbruch, oder auch elektrische Kurzschlüsse auftreten. Überlast-Beschleunigungen können jedoch auch zu größeren Auslenkungen der beweglichen Teile und damit zu entsprechenden Beschädigungen führen. Deshalb ist der bekannte Beschleunigungssensor mit Anschlägen für die Torsionsfedern ausgestattet. Diese Anschläge sind jeweils im Verbindungsbereich zwischen Torsionsfeder und Wippe angeordnet und starr mit dem Substrat des Bauelements verbunden, so dass die Auslenkung der Torsionsfedern bzw. die Bewegung der Wippe in der x/y-Ebene, d.h. parallel zur Chipebene, begrenzt ist. Die Geometrie der Anschläge ist nicht an die zu erwartende Deformation und Auslenkung der Torsionsfedern angepasst, so dass sich die Anschläge und die Torsionsfedern im Fall einer entsprechenden Überlast-Beschleunigung lediglich punktuell bzw. kantig berühren.

Bezüglich einer Beschleunigung in z-Richtung müssen zwei Fälle unterschieden werden, eine Beschleunigung in das Substrat hinein und eine Beschleunigung aus dem Substrat heraus. Im erstgenannten Fall lässt sich die Bewegung der Torsionsfeder bzw. der seismischen Masse einfach durch einen Anschlag an einer elektrisch neutralen Substratstelle begrenzen. Eine Bewegung der seismischen Masse aus dem Substrat heraus, wie sie im zweitgenannten Fall zu erwarten ist, lässt sich dagegen nicht ohne weiteres begrenzen. So können bei einer Strukturhöhe von ca. 10 µm bereits Auslenkungen ab 10 µm zu einem Herausheben der seismischen Masse aus dem Umgebungsniveau und in Folge zu einem Verhaken der Sensorstruktur führen.

Bei ungerichteten Fallversuchen mit dem bekannten Beschleunigungssensor wurden Muschelausbrüche am äußeren Rand der Anschläge und an der Torsionsfeder festgestellt. Derartige Muschelausbrüche können die mechanischen Eigenschaften der Federanordnung verändern oder zu einem Risswachstum als Vorschädigung der Sensorstruktur führen. Dadurch bedingt können sich die Kenndaten des Sensors, wie Empfindlichkeit, Offset und Testsignal, verändern. Zudem sind Muschelausbrüche eine Quelle für Partikel, die elektrische Kurzschlüsse oder auch eine mechanische Blockierung der Wippe verursachen können. Insgesamt führen die vorgenannten Muschelausbrüche in der Regel zu einer qualitätsrelevanten Beeinträchtigung der Sensorfunktion und können im Extremfall sogar zum Totalausfall der Sensorfunktion führen.

Die Schrift JP 09127151 A beschreibt einen mikromechanischen Sensor mit einer mittels Federanordnung aufgehängten seismischem Masse und einem aus parallel zueinander angeordneten Biegefedern bestehenden Überlastschutz zur Begrenzung der Auslenkung der seismischem Masse.

### Vorteile der Erfindung

Mit der vorliegenden Erfindung werden zwei konstruktive Maßnahmen vorgeschlagen, mit denen sich die Anschlagkräfte bei einem Sensor der eingangs genannten Art reduzieren lassen, um Muschelausbrüche und dadurch bedingte Vorschädigungen der Sensorstruktur sowie eine Partikelbildung zu vermeiden.

Erfindungsgemäß wird vorgeschlagen, dass ein als Überlastschutz dienender Anschlag für ein bewegliches Teil der Sensorstruktur federnd ausgebildet ist. In diesem Fall werden die Anschlagkräfte reduziert, indem die kinetische Energie während des Anschlags zumindest teilweise in Biegeenergie umgewandelt wird. Die Umwandlung der kinetischen Energie in Biegeenergie kann durch das Design des federnden Anschlags beeinflusst werden.

Für die Ausgestaltung und Anordnung eines federnden Anschlags in der Sensorstruktur eines erfindungsgemäßen Sensors gibt es grundsätzlich verschiedene Möglichkeiten.

Ein besonders sanftes, allmähliches Abbremsen der beweglichen Teile der Sensorstruktur lässt sich in vorteilhafter Weise mit Hilfe eines mehrstufig ausgebildeten federnden Anschlags erreichen, der mehrere im wesentlichen parallel zueinander angeordnete einseitig mit dem Substrat verbundene Biegefedern umfasst. Als freie Designparameter, über die sich die Umwandlung der kinetischen Energie in Biegeenergie beeinflussen lässt, stehen hier die Länge und Breite der Biegefeder zur Verfügung. Je nach dem, welche Federwirkung erzielt werden soll, können sich die Biegefedern eines solchen mehrstufigen federnden Anschlags in ihrer Länge und/oder in ihrer Breite unterscheiden. Die Federwirkung hängt hier außerdem noch von den Abständen zwischen den einzelnen Biegefedern ab, d.h. davon, wie weit eine Biegefeder des mehrstufigen federnden Anschlags ausgelenkt werden kann, ohne die benachbarten Biegefedern des Anschlags zu tangieren. Dieser Abstand kann unabhängig von der Länge und Breite der einzelnen Biegefedern in vorteilhafter Weise mit Hilfe von Noppen vorgegeben werden, die vorzugsweise im Bereich der freien Enden an den einzelnen Biegefedern ausgebildet sind.

In einer vorteilhaften Variante des erfindungsgemäßen Sensors ist für mindestens eine Feder der Federanordnung mindestens ein mehrstufigen federnder Anschlag vorgesehen. In diesem Zusammenhang erweist es sich als vorteilhaft, wenn die mindestens eine Biegefeder des federnden Anschlags im wesentlichen parallel zu der Feder angeordnet ist, so dass das mit der seismischen Masse verbundene Ende der Feder und das freie Ende der mehrstufigen Biegefeder in dieselbe Richtung weisen. Bei einer solchen Anordnung von Feder und Biegefeder kann die Biegefeder der Bewegung der Feder folgen und die Bewegung der Feder so besonders sanft abbremsen.

Ergänzend dazu kann mindestens ein federnder Anschlag für die seismische Masse vorgesehen sein. In einer ersten Sensorvariante könnte der federnde Anschlag dazu einfach im wesentlichen parallel zu einer Seite der seismischen Masse angeordnet sein. Aus Platzgründen ist es jedoch von Vorteil, wenn die seismische Masse mindestens einen Ausschnitt aufweist und die mindestens eine Biegefeder des federnden Anschlags im wesentlichen parallel zu mindestens einer Seitenwandung dieses Ausschnitts angeordnet ist. Eine besonders gute Bremswirkung kann erzielt werden, wenn sich der Ausschnitt im Randbereich der seismischen Masse befindet und die mindestens eine Biegefeder des federnden Anschlags so angeordnet ist, dass zumindest ihr freies Ende in den Ausschnitt hineinragt.

Federnde Anschläge, wie sie voranstehend erläutert worden sind, lassen sich in vorteilhafter Weise in die mikromechanische Sensorstruktur eines erfindungsgemäßen Sensors integrieren, wenn diese Anschläge die Auslenkung der Federanordnung bzw. der seismischen Masse lediglich in x/y-Richtung begrenzen sollen, d.h. Auslenkungen innerhalb einer Ebene, die parallel zur Hauptebene des Bauelements orientiert sind. Muschelausbrüchen und einer damit verbundenen Partikelbildung kann in diesem Fall zusätzlich vorgebeugt werden, indem zumindest ein Teil der Eckbereiche in der Sensorstruktur mit Verrundungen versehen ist bzw. abgerundet ist.

### Zeichnungen

Wie bereits voranstehend ausführlich erörtert, gibt es verschiedene Möglichkeiten, die Lehre der vorliegenden Erfindung in vorteilhafter Weise auszugestalten und weiterzubilden. Dazu wird einerseits auf die von Patentanspruch 1 abhängigen Patentansprüchen und andererseits auf die nachfolgende Erläuterung mehrerer Ausführungsbeispiele der Erfindung anhand der Zeichnungen verwiesen.
- Fig. 1: zeigt einen Ausschnitt einer herkömmlichen Sensorstruktur mit einem flächigen Anschlag in Draufsicht,
- Fig. 2: zeigt einen Ausschnitt einer Sensorstruktur mit einem federnden Anschlag eines weiteren erfindungsgemäßen Sensors in Draufsicht,
- Fig. 3: zeigt verschiedene Anschlagpositionen an der seismischen Masse eines erfindungsgemäßen Sensors,
- Fig. 4: zeigt einen Ausschnitt einer Sensorstruktur mit einem federnden Anschlag eines weiteren erfindungsgemäßen Sensors in Draufsicht und
- Fig. 5: zeigt weitere mögliche Anschlagpositionen an der seismischen Masse eines erfindungsgemäßen Sensors.

### Beschreibung der Ausführungsbeispiele

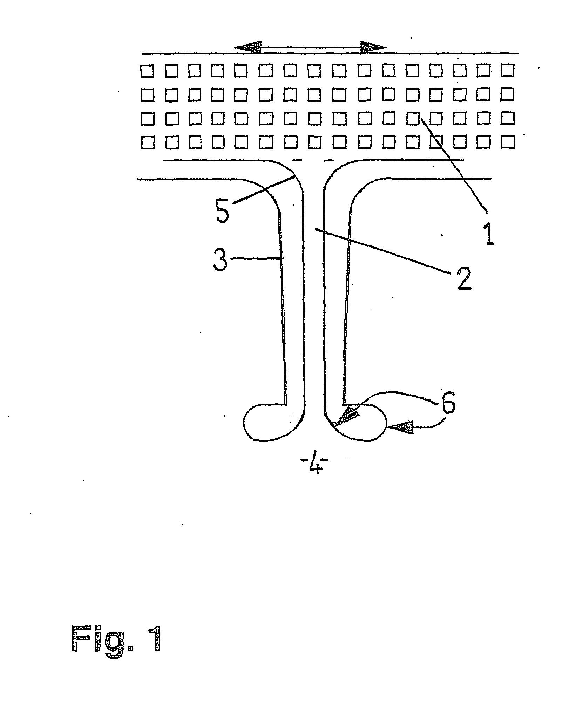

Jede der in den Figuren 1 bis 5 dargestellten Sensorstrukturen ist in einem mikromechanischen Bauelement realisiert und umfasst Teile, die gegenüber dem feststehenden Substrat des Bauelements beweglich sind, nämlich eine freitragende seismische Masse 1 und eine Federanordnung mit mindestens einer Feder 2. Die seismische Masse 1 ist über die Federanordnung mit dem Substrat verbunden, so dass die Massenverteilung der seismischen Masse 1 unsymmetrisch bezüglich der Federanordnung ist. Alle in den Figuren 1 bis 5 dargestellten Sensorstrukturen sind für den Einsatz in einem Beschleunigungssensor mit horizontaler und vertikaler Empfindlichkeit konzipiert, indem die freitragende seismische Masse 1 in Form einer Wippe ausgebildet ist und die Federanordnung mindestens eine Torsionsfeder 2 umfasst. Auf die Sensorstruktur einwirkende Beschleunigungen werden hier über die entsprechenden Auslenkungen der Federanordnung bzw. der seismischen Masse erfasst und bestimmt.

Außerdem ist in jeder der in den Figuren 1 bis 5 dargestellten Sensorstrukturen ein Überlastschutz zum Begrenzen der Auslenkung der Federanordnung bzw. der seismischen Masse in mindestens einer Richtung vorgesehen.

Die in Fig. 1 dargestellte herkömmliche Sensorstruktur weist einen flächigen Anschlag 3 als Überlastschutz für die Torsionsfeder 2 auf. Dieser flächige Anschlag 3 ist in Form einer auf das Substrat aufgebrachten festen Struktur realisiert und begrenzt die Auslenkung der Torsionsfeder 2 in x/y-Richtung, d.h. innerhalb einer Ebene, die parallel zur Hauptebene des Bauelements orientiert ist. Um ein kantiges Anschlagen der Torsionsfeder 2 zu vermeiden und ein flächiges Anschlagen zu gewährleisten; ist der Anschlag 3 als Flanke ausgebildet, deren Schräge von der Biegelinie der Torsionsfeder 2 abgeleitet worden ist. Alternativ könnte der flächige Anschlag auch eine Krümmung aufweisen, beispielsweise die Krümmung einer Hyperbel.

Die Torsionsfeder 2 der in Fig. 1 dargestellten herkömmlichen Sensorstruktur weist sowohl im Übergangsbereich zur seismischen Masse 1 als auch im Übergangsbereich zum sogenannten Festland 4, d.h. zu dem Bereich, in dem die Torsionsfeder 2 mit dem Substrat des Bauelements verbunden ist, eine Verrundung 5, 6 auf. Diese Verrundungen 5 und 6 dienen zur Spannungsreduktion bei vertikalen Auslenkungen der Torsionsfeder 2, d.h. bei Auslenkungen senkrecht zur Hauptebene des Bauelements. Dadurch lässt sich die Bruchwahrscheinlichkeit bei Falltests reduzieren.

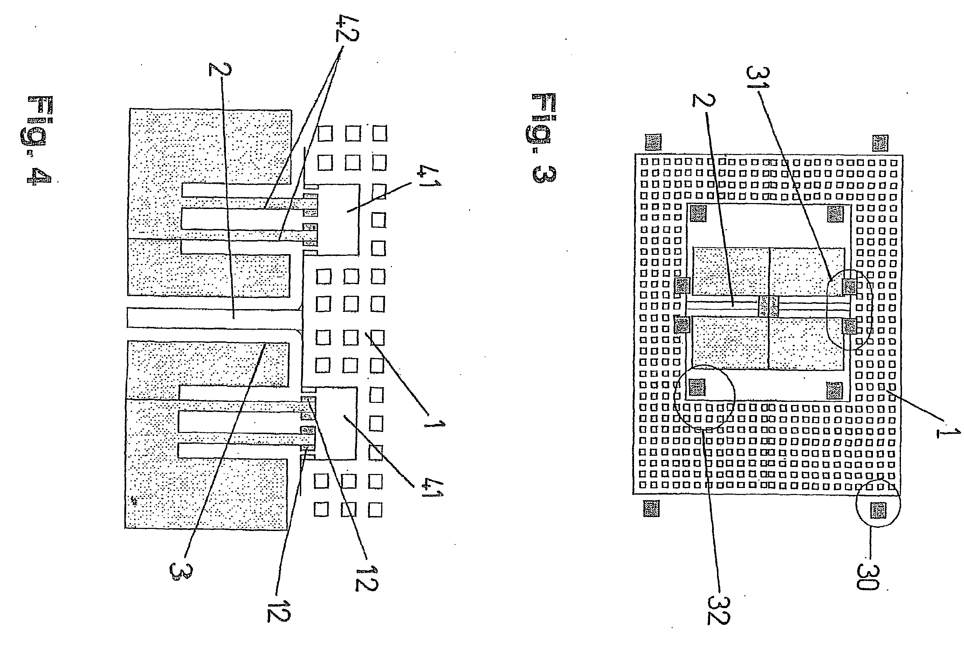

Im Zusammenhang mit Fig. 1 sei noch angemerkt, dass auch für andere bewegliche Teile der Sensorstruktur, nämlich beispielsweise für die seismische Masse, ein Anschlag als Überlastschutz vorgesehen sein kann. Die verschiedenen Möglichkeiten für die Anordnung eines solchen Anschlags in der Sensorstruktur werden in Verbindung mit den Figuren 3 und 5 näher erläutert.

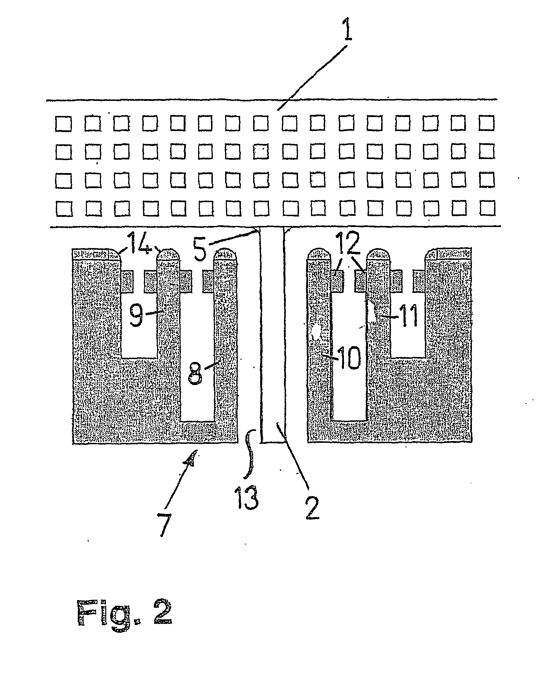

In Fig. 2 ist ein erfindungsgemäßer mehrstufiger federnder Anschlag 7 für die Torsionsfeder 2 dargestellt, der - genau wie der in Fig.1 dargestellte flächige Anschlag - die Auslenkung der Torsionsfeder 2 in x/y-Richtung begrenzt. Dazu umfasst der federnde Anschlag insgesamt vier Biegefedern 8, 9 und 10, 11, die beidseitig der Torsionsfeder 2, im wesentlichen parallel zu dieser angeordnet sind. Die Biegefedern 8, 9 und 10, 11 sind jeweils einseitig mit dem Substrat des Bauelements verbunden, so dass ihre freien Enden und das mit der seismischen Masse 1 verbundene Ende der Torsionsfeder 2 in dieselbe Richtung weisen. Die einzelnen Biegefedern 8, 9 und 10, 11 des hier dargestellten federnden Anschlags unterscheiden sich in ihrer Länge. So sind die inneren, der Torsionsfeder 2 unmittelbar benachbarten Biegefedern 8 und 10 deutlich länger als die beiden Biegefedern 9 und 11. Die Auslenkung der einzelnen Biegefedern 8, 9 und 10, 11 wird durch Noppen 12 begrenzt, die jeweils im Bereich der freien Enden der Biegefedern 8, 9 und 10, 11 ausgebildet sind. Außerdem sind die freien Enden der Biegefedern 8, 9 und 10, 11 mit Verrundungen 14 versehen, um Muschelausbrüchen in diesem Bereich vorzubeugen.

Der Mittelkanal 13 zwischen den beiden inneren Biegefedern 8 und 10 bildet eine Führung für die Torsionsfeder 2 bei vertikalen Beschleunigungen, die zu einem Herausheben der seismischen Masse 1 aus der Substratebene führen. Der Mittelkanal 13 verhindert in diesen Fällen ein Verhaken der seismischen Masse 1 bei der Rückkehr in die Ausgangslage. In den Mittelkanal 13 sollten deshalb keine Noppen hineinragen. Außerdem sollten die Biegefedern 8, 9 und 10, 11 eine kritische Biegesteifigkeit nicht unterschreiten, um einem Anhaften der Torsionsfeder 2 an den Biegefedern 8 und 10 entgegenzuwirken. Die kritische Biegesteifigkeit wird in der Regel experimentell bestimmt, wobei Erfahrungen mit vergleichbaren ähnlichen Sensorstrukturen Anhaltspunkte liefern können.

In einer besonders vorteilhaften Variante der in Fig. 2 dargestellten Sensorstruktur sind die der Torsionsfeder 2 zugewandten Seiten der Biegefedern 8 und 10 abgeschrägt, so dass auch an dem federnden Anschlag kein kantiges sondern ein flächiges Anschlagen erfolgt.
In der Sensorstruktur eines erfindungsgemäßen Sensors können zusätzlich zu den voranstehend beschriebenen, als Überlastschutz dienenden Anschlägen auch flächige und/oder federnde Anschläge für die seismische Masse vorgesehen sein. In Fig. 3 sind verschiedene Möglichkeiten für die Positionierung solcher Anschläge dargestellt. Dafür kommen im wesentlichen drei Bereiche in Frage: der Bereich direkt an der Torsionsfeder 2 - Anschläge 31, ein Bereich am inneren Rand der seismischen Masse 1 - Anschläge 32 - und der äußere Bereich der seismischen Masse 1 - Anschläge 33.

Die im äußeren Randbereich der seismischen Masse 1 angeordneten Anschläge 33 haben den Vorteil, dass die Bewegung der seismischen Masse 1 bei Rotationsbeschleunigungen schon bei geringen Auslenkungen im Anschlag endet. Dementsprechend gering ist der Impulsübertrag.

Wie bereits erwähnt, kann es bei Beschleunigungen senkrecht zur Hauptebene des Bauelements zu einem Herausheben der seismischen Masse aus der Sensorstruktur kommen und in Folge zu einem Verhaken der Sensorstruktur, sofern die Bewegung der seismischen Masse in dieser z-Richtung nicht begrenzt wird. Wenn kein entsprechender z-Anschlag vorhanden ist, erweist es sich als vorteilhaft, die Anschläge möglichst dicht an der Drehachse der seismischen Masse zu positionieren, da das Herausheben der seismischen Masse an dieser Stelle der Sensorstruktur minimal ist.

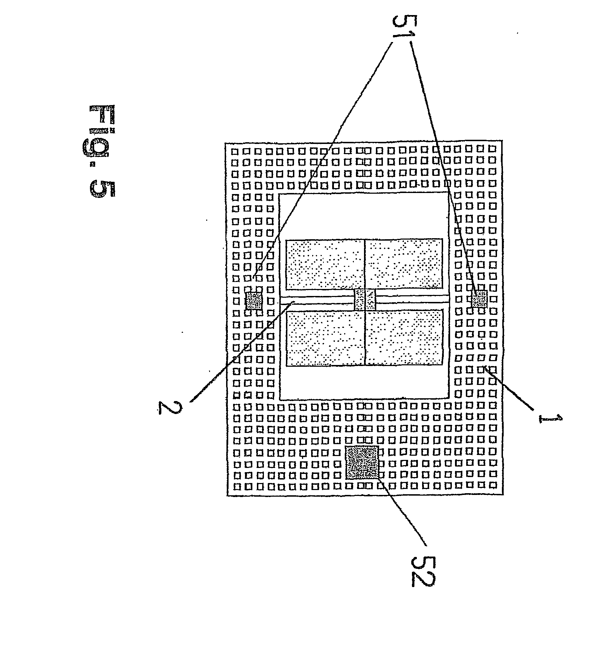

In Fig. 4 ist eine Möglichkeit für die Realisierung eines federnden Anschlags an der seismischen Masse 1 dargestellt. Die seismische Masse ist hier mit zwei Ausschnitten 41 im Randbereich versehen. In jeden dieser Ausschnitte 41 ragen die freien Enden von zwei Biegefedern 42, die jeweils im wesentlichen parallel zu den Seitenwandungen der beiden Ausschnitte 41 angeordnet sind. Die freien Enden der Biegefedern 42 sowie die Seitenwandungen der Ausschnitte 41 sind hier jeweils mit Noppen versehen, so dass sich die dadurch ergebenden Anschlagabstände zwischen den Biegefedern 42 innerhalb eines Ausschnitts 41 und den Seitenwandungen des entsprechenden Ausschnitts 41 unterscheiden. Dadurch ergibt sich ein stufenweiser Anschlag. Außerdem ist die Biegesteifigkeit der Biegefedern 42, die durch die jeweilige Länge und Breite der Biegefedern 42 beeinflusst wird, so gewählt, dass die sich daraus ergebenden Rückstellkräfte groß genug sind, um ein Anhaften der Biegefedern 42 an der seismischen Masse 1 zu verhindern.

Schließlich sei noch darauf hingewiesen, dass der voranstehend beschriebene federnde Anschlag für die seismische Masse mit den in Verbindung mit Fig. 1 beschriebenen Verrundungen der Torsionsfeder 2 kombiniert werden kann.

Grundsätzlich besteht auch die Möglichkeit, Anschläge 51, 52 innerhalb der seismischen Masse 1 zu positionieren, was in Fig. 5 dargestellt ist. Die Anschläge 51 befinden sich in Verlängerung der Torsionsfeder 2 innerhalb der Aufhängungen der Kapazitätsflächen, über die hier die Auslenkungen der seismischen Masse bestimmt werden. Diese Anordnung der Anschläge 51 ermöglicht eine einfache elektrische Kontaktierung.

Bei der Positionierung von Anschlägen in einer Sensorstruktur, wie sie Teil eines erfindungsgemäßen Sensors ist, sind folgende Aspekte zu berücksichtigen:

Anschläge, die die Bewegung zumindest einer Feder der Federanordnung in x/y-Richtung begrenzen, wirken zusätzlich auch als Führung für die Feder, wenn die seismische Masse durch vertikale Beschleunigungen aus der x/y-Ebene herausgehoben wird, so dass die seismische Masse wieder in ihre Ausgangslage zurückgleiten kann. Überlast-Beschleunigungen in z-Richtung führen bei dieser Variante nicht zwangsläufig zu einem Ausfall der Sensorfunktion. Allerdings können diese Anschläge die Sensoreigenschaften, wie z.B. die Empfindlichkeit, das Testsignal und den Offset, bei Vorschädigungen wesentlich beeinflussen, da die federn der Federanordnung eine mechanisch sehr empfindliche Struktur darstellen.

Im Gegensatz dazu tangieren Anschläge, die die Bewegung der seismischen Masse in x/y-Richtung begrenzen, die mechanischen Eigenschaften und die Funktionsfähigkeit der Federanordnung nicht. Allerdings wirken diese Anschläge auch nicht als Führung bei Auslenkungen der seismischen Masse in z-Richtung, so dass sich die seismische Masse hier einfacher verhaken und auf der Sensorstruktur liegen bleiben kann, was mit einem Ausfall der Sensorfunktion verbunden ist. Außerdem kann hier eine Vorschädigung der Sensorstruktur durch Partikelbildung nicht erkannt werden, weil die Sensoreigenschaften bzw. die Kennlinienparameter keine Änderungen erfahren. Störungen der Sensorfunktion, die durch wandernde Partikel bedingt sind, können ebenfalls nicht erkannt werden.

## Patentansprüche

1. Sensor, dessen Sensorstruktur in einem mikromechanischen Bauelement realisiert ist und gegenüber dem feststehenden Substrat des Bauelements bewegliche Teile aufweist, mindestens umfassend
- eine freitragende seismische Masse (1),
- eine Federanordnung mit mindestens einer Feder (2), wobei die seismische Masse (1) über die Federanordnung mit dem Substrat verbunden ist,
- einen Überlastschutz zum Begrenzen der Auslenkung der Federanordnung bzw. der seismischen Masse (1) in mindestens einer Richtung und
- Mittel zum Erfassen der Auslenkungen der Federanordnung bzw. der seismischen Masse (1),
- wobei als Überlastschutz mindestens ein federnder Anschlag (7) für mindestens ein bewegliches Teil der Sensorstruktur vorgesehen ist,
**dadurch gekennzeichnet, dass**
- der federnde Anschlag (7) zum Begrenzen der Auslenkung der Federanordnung bzw. der seismischen Masse (1) in der einen Richtung mehrstufig ausgebildet ist, indem er mindestens zwei im wesentlichen parallel zueinander angeordnete Biegefedern (8 bis 11) umfaßt,
- wobei die mindestens zwei Biegefedern (8 bis 11) einseitig mit dem Substrat verbunden sind.

2. Sensor nach Anspruch 1, **dadurch gekennzeichnet, dass** sich die Biegefedern (8 bis 11) des mehrstufigen federnden Anschlags (7) in ihrer Länge und/oder in ihrer Breite unterscheiden.

3. Sensor nach einem der Ansprüche 1 oder 2, **dadurch gekennzeichnet, dass** an der mindestens einen Biegefeder (8 bis 11) vorzugsweise im Bereich ihres freien Endes mindestens eine Noppe (12) ausgebildet ist und dass zumindest ein Bereich der Noppenoberfläche eine Anschlagfläche der Biegefeder (8 bis 11) bildet.

4. Sensor nach einem der Ansprüche 1 bis 3, **dadurch gekennzeichnet, dass** mindestens ein federnder Anschlag (7) für mindestens eine Feder (2) der Federanordnung vorgesehen ist.

5. Sensor nach einem der Ansprüche 1 bis 3 und nach Anspruch 4, **dadurch gekennzeichnet, dass** die mindestens eine Biegefeder (8 bis 11) des federnden Anschlags (7) im Wesentlichen parallel zu der Feder (2) der Federanordnung angeordnet ist, so dass das mit der seismischen Masse (1) verbundene Ende der Feder (2) und das freie Ende der Biegefeder (8 bis 11) in dieselbe Richtung weisen.

6. Sensor nach einem der Ansprüche 1 bis 5, **dadurch gekennzeichnet, dass** mindestens ein federnder Anschlag für die seismische Masse (1) vorgesehen ist.

7. Sensor nach einem der Ansprüche 1 bis 3 und nach Anspruch 6, **dadurch gekennzeichnet, dass** die seismische Masse (1) mindestens eine Ausschnitt (41) aufweist und dass die mindestens eine Biegefeder (42) des federnden Anschlags im Wesentlichen parallel zu mindestens einer Seitenwandung des Ausschnitts (41) angeordnet ist.

8. Sensor nach Anspruch 7, **dadurch gekennzeichnet, dass** sich der Ausschnitt (41) im Randbereich der seismischen Masse (1) befindet und dass die mindestens eine Biegefeder (42) so angeordnet ist, dass zumindest ihr freies Ende in den Ausschnitt (41) hineinragt.

9. Sensor nach einem der Ansprüche 1 bis 8, **dadurch gekennzeichnet, dass** der Anschlag (7) die Auslenkung der Federanordnung bzw. der seismischen Masse (1) in x/y-Richtung begrenzt, d. h. innerhalb einer Ebene, die parallel zur Hauptebene des Bauelements orientiert ist.

10. Sensor nach Anspruch 9, **dadurch gekennzeichnet, dass** zumindest ein Teil der Eckbereiche in der Sensorstruktur mit Verrundungen (5, 6, 14) versehen ist bzw. abgerundet ist.

11. Beschleunigungssensor mit horizontaler und vertikaler Empfindlichkeit nach einem der Ansprüche 1 bis 10, **dadurch gekennzeichnet, dass** die freitragende seismische Masse (1) in Form einer Wippe ausgebildet ist und dass die Federanordnung mindestens eine Torsionsfeder (2) umfasst.

## Claims

1. Sensor whose sensor structure is implemented in a micromechanical component and has parts which can be moved relative to the stationary substrate of the component, said sensor at least comprising
- a self-supporting seismic mass (1),
- a spring arrangement having at least one spring (2), the seismic mass (1) being connected to the substrate by means of the spring arrangement,
- overload protection for limiting the deflection of the spring arrangement and of the seismic mass (1) in at least one direction, and
- means for detecting the deflection of the spring arrangement and of the seismic mass (1),
- at least one resilient stop (7) being provided as overload protection for at least one movable part of the sensor structure,
**characterized in that**
- the resilient stop (7) for limiting the deflection of the spring arrangement and of the seismic mass (1) in one direction is of multistage design by virtue of it comprising at least two spiral springs (8 to 11) which are arranged essentially parallel to one another,
- the at least two spiral springs (8 to 11) being connected to the substrate on one side.

2. Sensor according to Claim 1, **characterized in that** the spiral springs (8 to 11) of the multistage resilient stop (7) differ in terms of their length and/or width.

3. Sensor according to either of Claims 1 and 2, **characterized in that** at least one bump (12) is formed on the at least one spiral spring (8 to 11), preferably in the region of the free end of the latter, and **in that** at least one region of the bump surface forms a stop surface of the spiral spring (8 to 11).

4. Sensor according to one of Claims 1 to 3, **characterized in that** at least one resilient stop (7) is provided for at least one spring (2) of the spring arrangement.

5. Sensor according to one of Claims 1 to 3 and according to Claim 4, **characterized in that** the at least one spiral spring (8 to 11) of the resilient stop (7) is arranged essentially parallel to the spring (2) of the spring arrangement, with the result that that end of the spring (2) which is connected to the seismic mass (1) and the free end of the spiral spring (8 to 11) point in the same direction.

6. Sensor according to one of Claims 1 to 5, **characterized in that** at least one resilient stop is provided for the seismic mass (1).

7. Sensor according to one of Claims 1 to 3 and according to Claim 6, **characterized in that** the seismic mass (1) has at least one cutout (41), and **in that** the at least one spiral spring (42) of the resilient stop is arranged essentially parallel to at least one side wall of the cutout (41).

8. Sensor according to Claim 7, **characterized in that** the cutout (41) is situated in the edge region of the seismic mass (1), and **in that** the at least one spiral spring (42) is arranged in such a manner that at least its free end projects into the cutout (41).

9. Sensor according to one of Claims 1 to 8, **characterized in that** the stop (7) limits the deflection of the spring arrangement and of the seismic mass (1) in the x/y direction, that is to say within a plane that is oriented parallel to the main plane of the component.

10. Sensor according to Claim 9, **characterized in that** at least some of the corner regions in the sensor structure are provided with rounded portions (5, 6, 14) or are rounded.

11. Acceleration sensor with horizontal and vertical sensitivity according to one of Claims 1 to 10, **characterized in that** the self-supporting seismic mass (1) is in the form of a rocker, and **in that** the spring arrangement comprises at least one torsion spring (2).

## Revendications

1. Capteur dont la structure est réalisée dans un composant de micromécanique et comporte des parties mobiles par rapport au substrat fixe du composant, comprenant au moins
* une masse sismique (1) en porte-à-faux,
* un dispositif de ressorts avec au moins un ressort (2), la masse sismique (1) étant reliée au substrat par le dispositif à ressorts,
* une protection de surcharge pour limiter le débattement du dispositif à ressorts ou de la masse sismique (1) dans au moins une direction et
* des moyens pour saisir le débattement du dispositif de ressorts ou de la masse sismique (1),
- la protection de surcharge comportant au moins une butée élastique (7) pour au moins une partie mobile de la structure de capteur,
**caractérisé en ce que**
- la butée élastique (7) limitant le débattement du dispositif de ressorts ou de la masse sismique (1) est à plusieurs étages dans une direction **en ce qu'**elle comprend au moins deux ressorts de flexion (8-11) pratiquement parallèles l'un à l'autre,
- au moins ces deux ressorts de flexion (8-11) sont reliés d'un côté au substrat.

2. Capteur selon la revendication 1,
**caractérisé en ce que** les ressorts de flexion (8-11) de la butée élastique (7) à plusieurs étages ont une longueur et/ou une largeur différente.

3. Capteur selon l'une des revendications 1 ou 2,
**caractérisé en ce qu'**
il y a au moins un bossage (12) à au moins un ressort de flexion (8-11), de préférence au niveau de son extrémité libre, et au moins une zone de la surface du bossage constitue une surface de butée pour les ressorts de flexion (8-11).

4. Capteur selon l'une des revendications 1 à 3,
**caractérisé par**
au moins une butée élastique (7) pour au moins un ressort (2) du dispositif de ressorts.

5. Capteur selon l'une des revendications 1 à 3 et 4,
**caractérisé en ce qu'**
au moins un ressort de flexion (8-11) de la butée élastique (7) est essentiellement parallèle au ressort (2) du dispositif de ressorts de façon que l'extrémité du ressort (2) reliée à la masse sismique (1) et l'extrémité du ressort de flexion (8-11) soient tournées dans la même direction.

6. Capteur selon l'une des revendications 1-5,
**caractérisé par**
au moins une butée élastique pour la masse sismique (1).

7. Capteur selon l'une des revendications 1 à 3 et selon la revendication 6,
**caractérisé en ce que**
la masse sismique (1) comportant au moins une découpe (41) et au moins un ressort de flexion (42) de la butée élastique est installée pratiquement parallèlement à au moins une paroi latérale de la découpe (41).

8. Capteur selon la revendication 7,
**caractérisé en ce que**
la découpe (41) se trouve dans la zone du bord de la masse sismique (1) et **en ce qu'**au moins un ressort de flexion (42) est disposé pour qu'au moins son extrémité libre pénètre dans la découpe (41).

9. Capteur selon l'une des revendications 1 à 8,
**caractérisé en ce que**
la butée (7) qui limite le débattement du dispositif de ressorts ou de la masse sismique (1) est limitée dans la direction x/y, c'est-à-dire dans un plan orienté parallèlement au plan principal du composant.

10. Capteur selon la revendication 9,
**caractérisé en ce qu'**
au moins une partie des zones de coin de la structure du capteur a des arrondis (5, 6, 14) ou est arrondie.

11. Capteur d'accélération à sensibilité horizontale et verticale selon l'une des revendications 1 à 10,
**caractérisé en ce que**
la masse sismique (1) en porte-à-faux est réalisée sous la forme d'une bascule et le dispositif de ressorts comporte au moins un ressort de torsion (2).
